# EUROPEAN PATENT APPLICATION

(11) **EP 0 767 536 A2**
(43) Date of publication of application: **09.04.1997**
(21) Application number: 96307223.6
(22) Date of filing: 02.10.1996
(51) Int. Cl.: H03K 5/151

(54) **An ECL clock phase shifter with CMOS digital control**

(30) Priority: 02.10.1995 US 4678; 04.01.1996 US 583169
(71) Applicant: NORTHERN TELECOM LIMITED, Montreal, Quebec H2Y 3Y4 (CA)
(72) Inventor: Guay, Bernard, Montreal, Quebec H3J 2W5 (CA); Altmann, Michael, Kanata, Ontario K2L 2KI (CA)
(74) Representative: Dennis, Mark Charles

(57) **Abstract**

A CML/ECL clock phase shifter device provides a 360° phase control range and, upon being provided with two CML clock signals related by a known phase difference, the device produces any desired phase in response to a control signal. The device uses a CMOS current switch which generates current signals having the amplitude adjustable with the control signal, which is a digital word. Differential pairs provide amplitude modulated current signals for the input clock and the variant of the input clock. Two MOS transmission networks selectively invert each amplitude modulated signal and sum the signals from each side on a load network. The phase control resolution is optimal over four quadrants for quadrature input clock signals.

## Description

### Field of the Invention

This invention relates to a phase shifter circuit and more specifically to a CLM/ECL phase shifter with CMOS digital control.

### Background of the Invention

The need often arises to generate phase shifted versions of a clock signal. Timing recovery circuits and delay-locked loops are two examples. Existing clock phase shifting circuits are based on cascaded delay cells, variable delay cells or mixing circuits. In the latter case, the output of the phase shift control is an analog signal which is prone to corruption by noise or crosstalk. Digital control can be achieved in this case through use of a digital-to-analog converter.

In some cases when CMOS and CML/ECL technologies are used in the same device, translators or resistive networks are needed to translate the CMOS control signal to an CML/ECL format. Provision of such circuits results in higher complexity and power dissipation.

In addition, mixed based clock phase shifter circuits typically have the phase control range limited to 90°.

CMOS and CML/ECL technologies are currently used within the same integrated circuit in an effort to reduce power dissipation and improve performance. Therefore, the need arises for a CMOS signal to act as the control signal for CML/ECL circuits, especially for high speed logic circuits.

### Summary of the Invention

It is a primary object of present invention to provide a mixer based CML/ECL clock phase shifter with CMOS digital control which overcomes totally or in part the drawbacks associated with the prior art phase shifters.

It is another object of the present invention to provide a CML/ECL phase shifter with a CMOS digital control signal which does not use translators or resistive networks to translate the CMOS control signal to an CML/ECL format.

The device of the present invention uses a CML/ECL arrangement, together with a complementary MOS current source with adjustable current output. The device combines the high speed CML/ECL logic signals with a low speed single-ended CMOS control signal and does not require a complementary input or reference signal.

It is still another object of the present invention to provide a clock phase shifter with an output clock having a phase that can be programmed to take any value between 0° and 360°.

The phase shifter according to the present invention provides a 360° phase control range and operates under the control of a CMOS digital word. Upon being provided with two CML clock signals related by a known fixed phase difference, the device produces any desired phase in response to a digital control signal. The phase control resolution is optimal and equal over the four quadrants for quadrature input clock signals.

Another object of the present invention is to achieve a very compact implementation of a mixer based clock phase shifter.

Accordingly, the invention is directed to a device for shifting the phase of a high-speed signal over a 360° phase control range, comprising a current switch for generating a first current in a first node and a second current in a second node in accordance with a control digital signal; a first differential block for receiving the high speed signal and the first current, amplitude modulating the high speed signal with the first current, and selectively directing the modulated high speed signal on a first and a second route; a second differential block for receiving a variant of the high speed signal having a known fixed phase difference with the high speed signal and the second current, amplitude modulating the high speed variant with the second current, and selectively directing the modulated high speed variant on a third and a fourth route; a first transmission circuit for connecting the first and second routes to a first summing node and to a second summing node according the control digital signal; a second transmission circuit for connecting the third and fourth routes to the first summing node and to the second summing node according to the control digital signal; and a load network connected to the first and second summing nodes for providing a high-speed output signal with a 360° phase control range.

An important advantage of the programmable phase shifter of the present invention is that compatibility is achieved between different signal types. The programmable features of this circuit are implemented using a hybrid CML-CMOS multiplexer block allowing direct interfacing of CMOS supervisory logic blocks to high speed CML signal paths. This is achieved without the need for CMOS to CML translators and thus represents a significant reduction in active area and power dissipation. Furthermore, this circuit structure does not affect the high frequency operation of the CML signal path. The approach can also be used for other signal types.

Another advantage of this invention is that the phase of the final recovered clock can be adjusted to provide an output range between 0° and 360°.

### Brief Description of the Drawings

The present invention will be described in the following in conjunction with the accompanying drawings in which:
**Figure 1** is a block diagram of the clock phase shifter circuit of the present invention;
**Figure 2** shows the variation of the output clock phase with the amplitude of the input clock signals;
**Figure 3** is a schematic diagram of the circuit of Figure 1;
**Figure 4** is a schematic diagram of a current switching circuit (prior art);
**Figure 5** is a block diagram of a variable current switching circuit according to this invention;
**Figure 6** is a block diagram of a clock recovery circuit with the clock phase shifter of this invention; and
**Figure 7** is a graph showing the output voltage against time for various values of the control signal.

### Description of the Preferred Embodiment

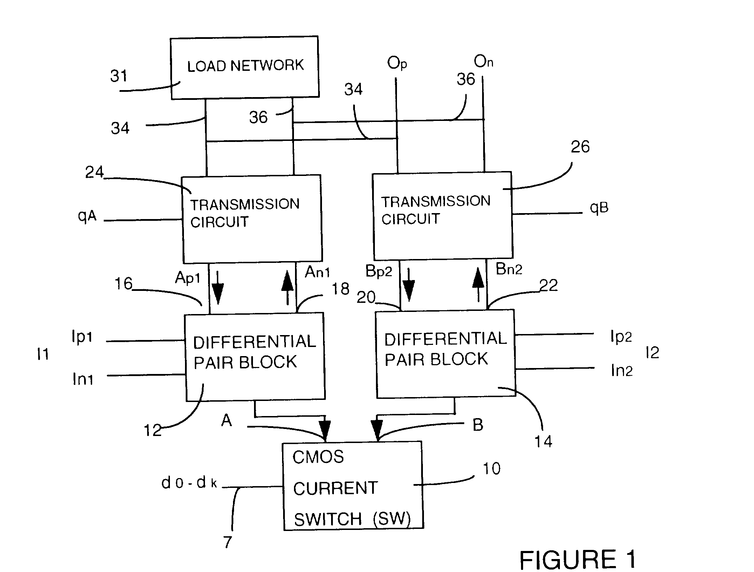

Figure 1 illustrates the block diagram of a phase shifter according to the present invention. A current switch **10** is connected to a first differential block **12** and a second differential block **14** to provide a first current at node A and a second current at node B. The amplitude of the output currents at A and B dependend on the digital word d₀ to dₖ applied to input **7**. CMOS current switch **10** is designed such that an increase in the amplitude of current on path A is mirrored by a similar decrease in the amplitude of the current on path B, and a decrease in the amplitude of current at node A is mirrored by a similar increase in the amplitude of the current at node B.

The first differential block **12** receives a CML/ECL high speed clock signal I₁, more precisely input signal Iₚ₁ and its inverse, Iₙ₁ (I₁ = Iₚ₁ + Iₙ₁). The second differential block **14** receives a variant I₂ of the high speed clock signal, namely input signal Iₚ₂ and its inverse, Iₙ₂ (I₂ = Iₚ₂ + Iₙ₂). The high speed signal I₁ and the variant I₂ of the high speed signal are in a known, fixed phase relationship. In the embodiment disclosed and illustrated, quadrature clock signals are used, but it is apparent to a person skilled in the art that the input clocks I₁ and I₂ need not necessarily be in quadrature and other phase relationships may be used.

Block **12** amplitude modulates the input clock signals Iₚ₁ and Iₙ₁ with the current at node A, and gives modulated signals on routes 16 and **18**. Route **16** carries a signal Aₚ₁ in phase with signal Iₚ₁ and with an amplitude corresponding to the amplitude of current at node A. Modulated signal Aₙ₁ on route **18** has the phase of signal Iₙ₁ and an amplitude corresponding to that of the current at node A.

Similarly, block **14** amplitude modulates the input quadrature clocks Iₚ₂ and Iₙ₂ with the current at node B, and gives modulated quadrature clock signals on output routes **20** and **22**. Output route **20** carries a modulated signal Bₚ₂ in phase with signal Iₚ₂ and with an amplitude corresponding to the amplitude of current at node B, while modulated signal Bₙ₂ on route **22** is in phase with signal Iₙ₂ and has the amplitude corresponding to that of current at node B. In this way, amplitude modulated clock signals I₁ and I₂ are available with both polarities and with mirrored amplitudes at the output of the differential pair.

For example, signal Aₚ₁ is obtained on route **16** when Iₚ₁ is present at the input of differential pair **12**. At the same time, the signal Bₚ₂ is obtained on route **20** as I_{p2,} which is a variant of Iₚ₁, and is present at the input of differential pair **14**. The sum of the normalized amplitudes of signals Aₚ₁ and Bₚ₂ on routes **18** and **22** is equal to unity. Similarly, the sum of the normalized amplitudes of signals Aₙ₁ and Bₙ₂ on routes **18** and **22** is equal to unity.

Two transmission circuits **24** and **26** reconfigure the signal paths of mixer differential pairs using quadrant defining signals q_{A} and q_{B}. Amplitude modulated signals Aₚ₁ and Aₙ₁, output by differential pair **12**, are input to the first transmission circuit **24** and amplitude modulated signals Bₚ₂ and Bₙ₂, output by differential pair **14**, are input to the second transmission circuit **26**. The transmission circuits **24** and **26** are used to selectively invert each modulated signal and to sum the differential signals in summing nodes **34** and **36** respectively, so that a 360° phase control range can be covered, according to the value of the quadrant signals q_{A} and q_{B}. In fact, the sum is obtained in the load network **31**, which can be a simple resistive network.

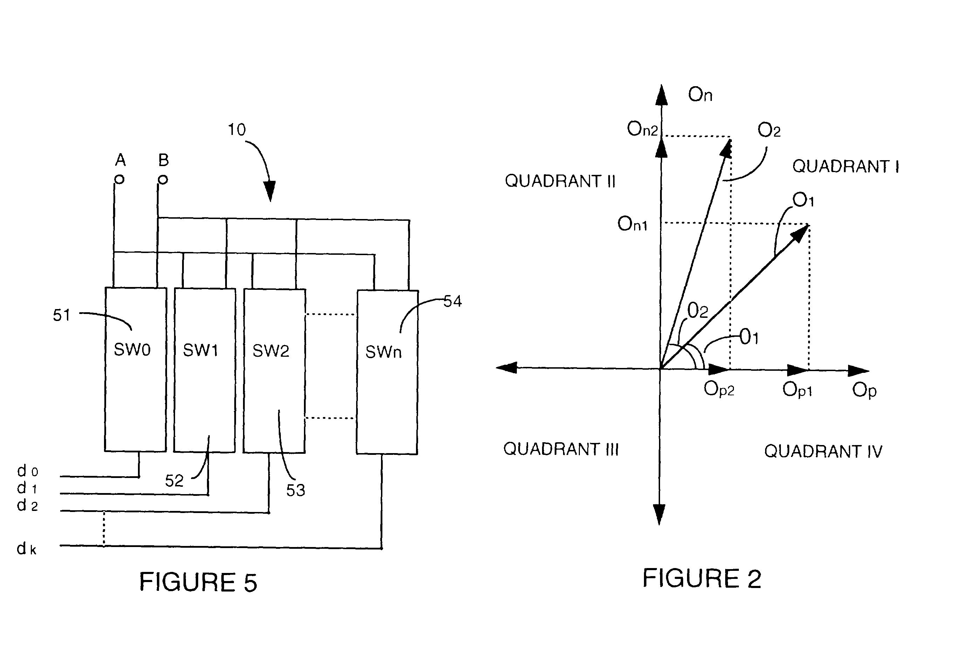

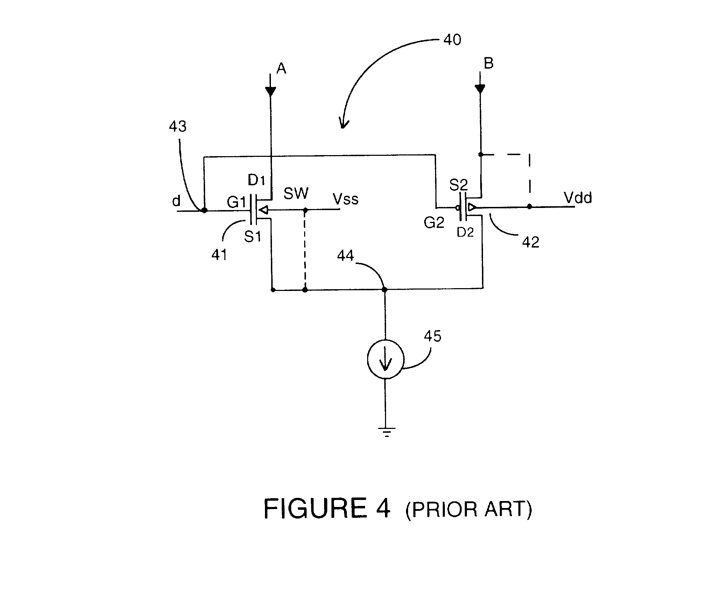

Figure 2 and Table 1 illustrate the variation of the output clock phase for various values of the quadrant signals q_{A} and q_{B}. The output signal Oₚ - Oₙ is obtained by combining phasors (O₁+ O₃) - (O₂ + O₄).

**Table 1**

| **q**_{**A**} | **q**_{**B**} | **Summing node 34** | **Summing node 36** | **Output O** | **Quadrant** |
|---|---|---|---|---|---|
| 0 | 0 | Aₚ₁+Bₚ₂ | Aₙ₁+Bₙ₂ | +Oₚ+Oₙ | I |
| 0 | 1 | Aₚ₁+Bₙ₂ | Aₙ₁+Bₚ₂ | +Oₚ-Oₙ | II |
| 1 | 1 | Aₙ₁+Bₙ₂ | Aₚ₁+Bₚ₂ | -Oₚ-Oₙ | III |
| 1 | 0 | Aₙ₂+Bₚ₂ | Aₚ₁+Bₙ₂ | -Oₚ+Oₙ | IV |

It is apparent to a person skilled in the art that phasors illustrated in Figure 2 and identified as Oₚ and Oₙ have an amplitude determined by the value of currents at node A or B and that the amplitude and phase of Oₚ and Oₙ determine the phase of the output signal O (O=Oₚ+Oₙ).

Angle θ of the output signal O is determined within the quadrant by the relationship between the amplitude of the two component phasors, while signals q_{A} and q_{B} determine the quadrant for the phase of the output clock signal.

As shown in Figures 1 and 2, and in Table 1, to obtain a recovered clock signal in the first quadrant I, both q_{A} and q_{B} should be logic "0". As can be seen in Figures 1 and 2, a signal at node **34** is formed with differential signals Aₚ₁ and Bₚ₂, and a signal at node **36** is formed with signals Aₙ₁ and Bₙ₂. The output signal O between nodes **34** and **36** is (Aₚ₁+Bₚ₂)-(Aₙ₁+Bₙ₂) = (Ap₁-Aₙ₁)+(Bₚ₂-Bₙ₂) = Oₚ+Oₙ. Output signals Oₚ and Oₙ have phase angles of 0° and 90° respectively and an amplitude as set according to currents A and B respectively. As illustrated in Figure 2, the output signal O₁, obtained by adding Oₚ₁ and Oₙ₁, will have a phase angle θ₁ between 0° and 90°. This angle may be varied by modifying the amplitude of the input clock signals that contribute to the final clock signal. For example, a different phase angle, θ₂ is obtained for a pair of phasors Oₙ₂ and Oₚ₂, giving an output clock O₂.

When signal Oₙ is positive and Oₚ is negative, the resulting output signal O will have a phase angle between 90° and 180°, depending on the amplitude of the currents in nodes A and B. In this case, when the output clock is in the second quadrant (II), q_{A} should be logic "0" and q_{B}, logic "1".

For an output clock in quadrant III, both q_{A} and q_{B} are logic "1". In this case, the output signal O will have a phase which may be varied between 180° and 270°, depending on the amplitude of signals Oₚ to Oₙ.

To obtain an output clock in quadrant IV, q_{A}, is logic "1"and q_{B} is logic "0". Signal Oₚ is positive and Oₙ, is negative, having phases 270° and 0° or 360° respectively. These signals are modulated with the current at node A and B respectively in the differential pairs. The phase of the output clock O may be varied between 270° and 360° by changing the amplitude of differential signals applied to the load network.

Load network **31** is connected across summing nodes **34** and **36** and serves, as indicated above, to add the differential signals for setting the phase of the output signals Oₚ, and Oₙ in accordance with the digital control signal d₀ - dₖ.

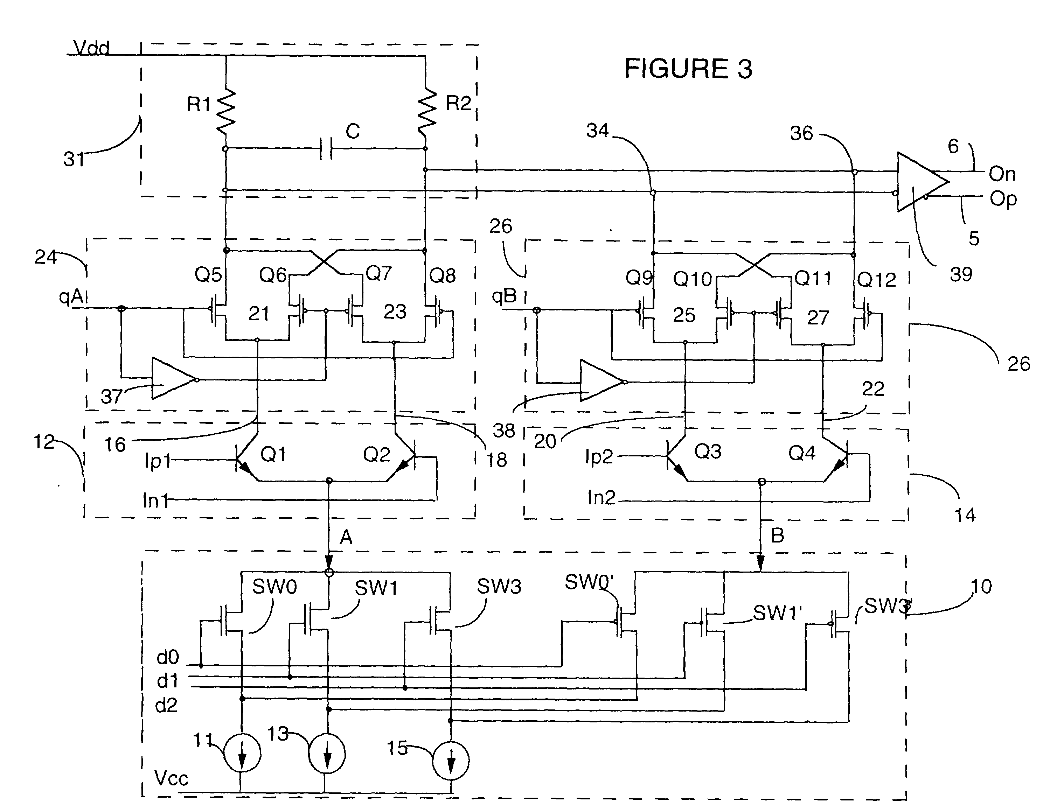

The electrical schematic of an embodiment of the invention is illustrated in Figure 3.

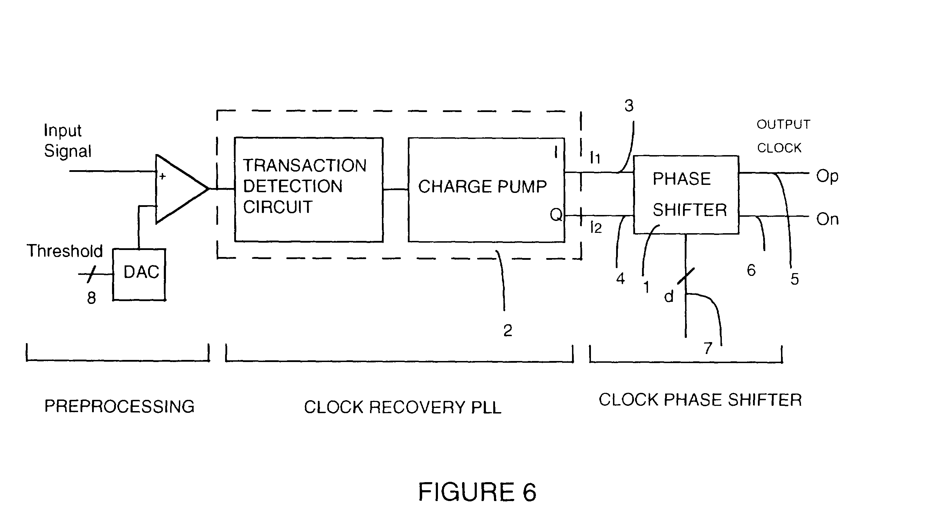

The CMOS current switches SW₀ to SWₘ and SW_{0'} to SWₘ' of CMOS pairs connected in a parallel arrangement. The operation of the switch will be explained later in further detail in connection with Figures 4 and 5. Three current sources **11**, **13** and **15** are each connected in series with a CMOS pair SW₀-SW_{0'}, SW₁-SW₁' to SW₃-SW₃', for giving weighted currents A and B. Current source **11**, for example, gives a current weighted with coefficient e₀ at node A or B, according to the level of signal d₀. Similarly, current source **13** gives a current weighted with coefficient e₁ at node A or B according to the level of signal d₁, and current source **15** gives a current weighted with coefficient e₂ at node A or B, according to the level of signal d₂. The values of the currents at nodes A and B determine the phase of the signal output, as discussed above in connection with Figures 1 and 2. It is apparent to a person skilled in the art that the number of current sources that may be used for the phase shifter may be selected according to the application, as will be explained in connection with Figures 4 and 5 in further detail. If higher resolution of the phase angle is desired, the number of current sources may be increased.

It is also apparent that the number k of digits of the control word is selected according to the number of current sources, and that the quadrant signals are preferably part of the control word.

The first differential pair **12** comprises bipolar transistors Q1 and Q2 which are used to modulate the input signals Iₚ₁ and Iₙ₁ with current A to give modulated signals Aₚ₁ and Aₙ₁ on output terminals **16** and **18**. The second differential pair **14** comprises bipolar transistors Q3 and Q4 which are used to modulate input signals Iₚ₂ and Iₙ₂ with current B to give modulated signals Bₚ₂ and Bₙ₂ on output terminal **20** or **22**.

The amplitude of modulated signals Aₚ₁, Aₙ₁, Bₚ₂, and Bₙ₂ output by differential pairs **12** and **14** is controlled using the CMOS logic controlled current switches connected to the emitter nodes of the differential pairs.

The first transmission circuit **24** comprises a first CMOS pair **21** made of devices Q5 and Q6 and a second pair **23** comprising devices Q7 and Q8. For each pair, the drains are connected together to receive the current in the collector of one of the transistors of the differential pair. Thus, the drains of the first CMOS pair **21** are connected to the collector of transistor Q1, and the drains of the second CMOS pair **23** are connected to the collector of transistor Q2. The sources of devices Q5 and Q7 are connected to node **34** and the sources of devices Q6 and Q8 are connected to node **36**.

The control terminals of devices Q5 and Q8 are connected together to receive quadrant signal q_{A}, while the control terminals of devices Q6 and Q7 are connected together to receive the inverted value of q_{A}. An inverter **37** is used for ensuring that devices Q5 and Q8 have a state opposite to the state of devices Q5 and Q6.

When q_{A} is high, Q5 and Q8 are "off" while Q6 and Q7 are "on". A modulated signal Aₚ₁ is obtained at summing node **34** through devices Q2 and Q7, and a modulated signal Bₙ₁ is obtained at summing node **36**. Thus, O₂ is obtained along a first track (T1) created between node A and summing node **36** through devices Q1 and Q6.

When q_{A} is low, Q5 and Q8 are "on" while Q6 and Q7 are "off". Now, Aₚ₁ is obtained at summing node **34**, through devices Q1 and Q5, while Aₙ₁ is obtained at summing node **36** through devices Q2 and Q8.

The second transmission circuit **26** comprises pairs **25** and **27**, controlled with quadrant signal q_{B}. As in the case of pairs **21** and **23**, the drains of devices Q9 and Q10 are connected together and to the collector of transistor Q3, and the drains of devices Q11 and Q12 are connected to the collector of transistor Q4. The sources of devices Q9 and Q11 are each connected to the summing node **34**, and the sources of devices Q11 and Q12 are connected to the summing node **36**.

The control terminals of devices Q9 and Q12 are connected together and receive quadrant signal q_{B}, while the control terminals of devices Q10 and Q11 are connected together to receive the inverted value of q_{B}. Inverter **38** is used for ensuring that Q10 and Q11 are "on" when Q9 and Q12 are "off".

When q_{B} is high, Q9 and Q12 are "off", while Q10 and Q11 are "on". Signal Bₚ₂ is applied on summing node **36** through devices Q3 and Q10, while signal Bₙ₂ is obtained at summing node **34** through devices Q4 and Q11.

When q_{B} is low, Q9 and Q12 are "on" while Q10 and Q11 are "off". Signal Bₚ₂ is obtained at summing node **34** through devices Q3, Q9, while a signal Bₙ₂ is obtained at summing node **36** through devices Q4 and Q12.

Signals output by the transmission circuits **24** and **26** are added on load resistors R1 and R2. Capacitor C is provided for filtering, to eliminate high frequency harmonics. The resulting output signals Oₚ and Oₙ are passed to a limiting amplifier **39** in order to regenerate a square wave clock output.

The basic current switch **40** which may be used for the CMOS current switch **10** is shown in Figure 4. This circuit is disclosed in United States Patent No. 5,420,529 (Guay et al., issued May 30, 1995 to Northern Telecom Limited).

The current switch **40** comprises NMOS device **41** and PMOS device **42**. Gates G1 and G2 of devices **41** and **42** are connected to node **43** for receiving the digital control signal d. Sources S1 and S2 are connected to node **44** and to a constant current source **45**. The current source **45** is connected at the other end to a negative supply rail which may, as shown, be tied to ground, although this is not essential. It is to be understood that the current source may consist of any current source circuit, as will be apparent to one skilled in the art.

The substrate of NMOS device **41** may be connected to Vₛₛ or to node **44**, while the substrate of PMOS **42** may be connected to Vdd or source S2, as illustrated in broken lines in Figure 4. The exact configuration chosen is not material to the invention. Drain D1 is connected to node A and source S2 is connected to node B.

The current switch **40** requires a single input and does not need a complementary input or reference level. Signal d is a CMOS input control signal.

In operation, the current from source **45** will be directed in either path between node A or node B and ground, in accordance to the input signal applied on terminal **43**. If the input voltage is low, NMOS device **41** is "off" and PMOS device **42** is "on", and the current generated by source **45** flows at node B. When the input voltage is high, device **41** is "on" and device **42** is "off". An output current generated by constant current source **45** will flow from node A to ground.

The region of operation of the complementary MOS devices in the "on" state will be determined by the circuit attached to nodes A and B. The complementary MOS devices are also selected so that their drain to source voltage in the "on" state is small enough to keep the current source in its high impedance region.

Figure 5 illustrates a block diagram of a the CMOS current switch **10** used in the present invention. The value of the currents may be adjusted if a plurality of current switches of the type illustrated in Figure 4 are connected in parallel. The value of output current at node A may be preset using the digital word d₀ to dₙ, which determines which of the current switches participate in forming this current.

The sources receiving logic "1" form the current at node A, and the sources receiving logic "0" form the current at node B. If, for example, a four digit control signal is applied on bus 7, with d₀ = 1, d₁ = 0, d₂ = 1 and d₃ = 1, the current at node A is formed with the currents generated by SW₀, SW₁ and SW₃, and the current at node B is formed by the current generated by SW₁.

A great flexibility in selecting the value of the current at node A may be obtained if different weights are attributed to each of SW₀ to SWₙ. Current switches with weighted current levels could be used, each giving a value of current incremented in binary steps. For example, current source **51** may be selected to have a weight of e₀, current source **52** a weight e₁, current source **53** a weight e₂, and the current source **54** a weight eₖ, where k is the number of sources less one.

Figure 6 generally illustrates a block diagram of an application of the phase shifter of this invention for a clock recovery circuit. As seen in Figure 1, the phase shifter **1** is connected at the output of clock recovery PLL block **2** and operates on the PLL output clock and its quadrature component. The phase shifter **1** receives the clock output I and the quadrature clock Q, on inputs **3** and **4** respectively. The output clocks Oₚ and Oₙ, obtained at terminals **5** and **6**, are phase controlled with a digital control signal d₀ to dₙ applied on terminal **7**.

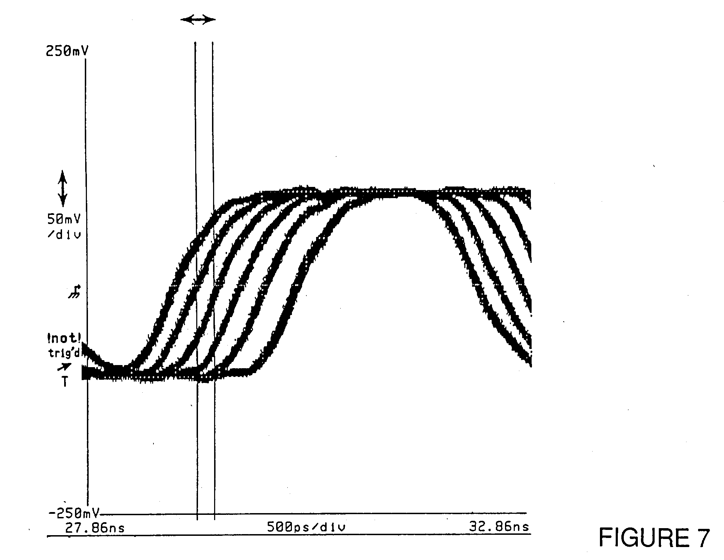

Figure 7 is an oscilloscope plot showing the measured effects of changing the control word to the phase shifter using an "infinite persistence" mode of display. The clock is running at 200MHz, and the phase shifter implemented has 8-bit resolution, namely two bits for q_{A} and q_{B}, and six bits resolution for the A and B weighted currents.

The illustrated step size of approximately 200ps is the result of changing the 4th least significant bit. Toggling the least significant bit would only amount to approximately 5ps change. This is below the resolution of the oscilloscope to show accurately.

While a specific embodiment of the invention has been illustrated and described it will be obvious to one skilled in the art that variations and alternatives can be made to the invention. Such variations and alternatives, however, are understood to come within the scope of the invention as defined by the appended claims.

## Claims

1. A device for shifting the phase of a high-speed signal over a 360° phase control range, comprising:
a current switch for generating a first current in a first node and a second current in a second node in accordance with a control digital signal;
a first differential block for receiving said high speed signal and said first current, amplitude modulating said high speed signal with said first current, and selectively directing said modulated high speed signal on a first and a second route;
a second differential block for receiving a variant of said high speed signal having a known fixed phase difference with said high speed signal and said second current, amplitude modulating said high speed variant with said second current, and selectively directing said modulated high speed variant on a third and a fourth route;
a first transmission circuit for connecting said first and second routes to a first summing node and to a second summing node according said control digital signal;
a second transmission circuit for connecting said third and fourth routes to said first summing node and to said second summing node according to said control digital signal; and
a load network connected to said first and second summing nodes for providing a high-speed output signal with a 360° phase control range.

2. A device as claimed in claim 1, wherein said first differential block comprises:
a first and a second semiconductor device having the emitters connected to said first node and the collectors connected to said first and second routes respectively;
means for applying said high speed signal on the base of said first semiconductor device; and
means for applying the inverse of said high speed signal on the base of said second semiconductor device.

3. A device as claimed in claim 1, wherein said second differential block comprises:
a third and a fourth semiconductor device having the emitters connected to said second node and the collectors connected to said third and fourth routes respectively;
means for applying said high speed signal on the base of said third semiconductor device; and
means for applying the inverse of said high speed signal on the base of said fourth semiconductor device.

4. A device as claimed in claim 1 wherein said first transmission circuit comprises:
a first switch connected with the common terminal to said first route and with the output terminals to said first and second summing node respectively, for switching said modulated high speed signal and the inverse of said modulated high speed signal between said first and second summing nodes according to a first quadrant digit comprised in said control digital signal; and
a second switch connected with the common terminal to said second route and with the output terminals to said first and second summing node respectively, for switching said modulated high speed variant and the inverse of said modulated high speed signal between said first and second summing nodes according to the inverse of said first quadrant digit.

5. A device as claimed in claim 4, wherein said first switch comprises a pair of CMOS devices having the drains connected together and to said first route, the sources connected to said first and second summing nodes respectively, and the gates connected to receive said first quadrant digit.

6. A device as claimed in claim 4, wherein said second switch comprises a pair of CMOS devices having the drains connected together and to said second route, the sources connected to said first and second summing nodes respectively, and the gates connected to receive said first inverse quadrant digit.

7. A device as claimed in claim 1 wherein said second transmission circuit comprises:
a third switch connected with the common terminal to said third route and with the output terminals to said first and second summing node respectively, for switching said modulated high speed variant and the inverse of said modulated high speed variant between said first and second summing nodes according to a second quadrant digit comprised in said control digital signal; and
a fourth switch connected with the common terminal to said fourth route and with the output terminals to said first and second summing node respectively, for switching said modulated high speed variant and the inverse of said modulated high speed variant between said first and second summing nodes according to said second inverse quadrant digit.

8. A device as claimed in claim 7, wherein said third switch comprises a pair of CMOS devices having the drains connected together and to said third route, the sources connected to said first and second summing nodes respectively, and the gates connected to receive said second quadrant digit.

9. A device as claimed in claim 7, wherein said fourth switch comprises a pair of CMOS devices having the drains connected together and to said fourth route, the sources connected to said first and second summing nodes respectively, and the gates connected to receive said second inverse quadrant digit.

10. A device as claimed in claim 1 wherein said load network comprises:
a first resistor connected between said first summing node and a power supply terminal; and
a second resistor connected between said second summing node and said power supply terminal.

11. A device as claimed in claim 12, wherein the sum of said constituent currents from said k pairs of CMOS devices form said first current and the sum of said complementary constituent currents from said k pairs of CMOS devices form said second current.

12. A device as claimed in claim 13, wherein the sum of the normalized amplitudes of said first and second currents obtained at said first and second nodes is equal to unity.

13. A device for shifting the phase of a high-speed signal over a 360° phase control range, comprising:
means for applying a first current on a first node and a second current in a second node, the amplitudes of said first and second currents being adjustable in accordance with a control digital signal;
a first differential block for receiving said high speed signal and said first current, amplitude modulating said high speed signal with said first current, and selectively directing said modulated high speed signal on a first and a second route;
a second differential block for receiving a variant of said high speed signal having a known fixed phase difference with said high speed signal and said second current, amplitude modulating said high speed variant with said second current, and selectively directing said modulated high speed variant on a third and a fourth route;
a first transmission circuit for connecting said first and second routes to a first summing node and to a second summing node according said control digital signal;
a second transmission circuit for connecting said third and fourth routes to said first summing node and to said second summing node according to said control digital signal; and
a load network connected to said first and second summing nodes for providing a high-speed output signal with a 360° phase control range.

14. A device as claimed in claim 14, wherein the sum of the normalized amplitudes of said first and second currents is equal to unity.

15. A device as claimed in claim 15, further comprising a current source for generating said first and said second currents.

16. A device as claimed in claim 2 wherein said first and second semiconductor devices are bipolar transistors.
